# EUROPEAN PATENT SPECIFICATION

(11) **EP 1 429 326 B1**
(45) Date of publication and mention of the grant of the patent: **29.10.2008**
(21) Application number: 02772822.9
(22) Date of filing: 29.08.2002
(51) Int. Cl.: C23C 14/34, C23C 14/06, G11B 7/26

(54) **SPUTTERING TARGET AND PRODUCTION METHOD THEREFOR AND OPTICAL RECORDING MEDIUM FORMED WITH PHASE-CHANGE TYPE OPTICAL DISK PROTECTION FILM**
SPUTTER-TARGET UND HERSTELLUNGSVERFAHREN DAFÜR UND OPTISCHES AUFZEICHNUNGSMEDIUM, AUSGEBILDET MIT EINEM SCHUTZFILM FÜR OPTISCHE PLATTEN DES PHASENÄNDERUNGSTYPS
CIBLE DE PULVERISATION CATHODIQUE ET PROCEDE DE PRODUCTION ASSOCIE, AINSI QUE SUPPORT D'ENREGISTREMENT OPTIQUE FORME AVEC UN FILM DE PROTECTION DE DISQUE OPTIQUE DE TYPE A CHANGEMENT DE PHASE

(30) Priority: 21.09.2001 JP 2001288116
(43) Date of publication of application: 16.06.2004
(73) Proprietor: Nippon Mining & Metals Co., Ltd., Minato-ku Tokyo (JP)
(72) Inventor: YAHAGI, Masataka, Isohara Nikko Fact. Mat. Co. Ltd, Kitaibaraki-shi, Ibaraki 319-1535 (JP); TAKAMI, Hideo, Isohara Nikko Fact. Mat. Co. Ltd, Kitaibaraki-shi, Ibaraki 319-1535 (JP)
(74) Representative: Hoarton, Lloyd Douglas Charles
(86) International application number: PCT/JP2002/008709
(87) International publication number: WO 2003/028023

(56) References cited:
- JP-A- 6 065 725
- JP-A- 11 229 128
- JP-A- 11 278 936
- JP-A- 11 335 823
- JP-A- 11 350 119
- JP-A- 11 350 121
- JP-A- 2000 026 960
- JP-A- 2000 144 397
- JP-A- 2000 219 962
- JP-A- 2000 234 168
- JP-A- 2001 039 771
- JP-A- 2001 152 325
- JP-A- 2002 309 368

## Description

### Technical Field

The present invention relates to a sputtering target having zinc sulfide-silicon oxide as its principal components and capable of reducing particles (dust emission) and nodules produced during sputtering upon forming a film with sputtering, which is of high density and having minimal variation in quality, and capable of improving mass productiveness, as well as to an optical recording medium having formed thereon the phase change optical disc protective film having zinc sulfide-silicon oxide as its principal components through the use of the foregoing target, and the manufacturing method of such a target.

### Background Art

In recent years, high-density recordable optical disc technology capable of reading/writing without requiring a magnetic head has been developed, and is rapidly attracting attention. This optical disc can be classified into the three categories of read-only, write-once and rewritable. Particularly, the phase change method employed in the rewritable type discs is attracting attention. The fundamental principle of the recording/reproduction employing this phase change optical disc is briefly described below.

This phase change optical disc performs the reading/writing of information by heating and increasing the temperature of a recording thin film on a substrate by irradiating a laser beam thereto, and generating a crystallographic phase change (amorphous⇔acrystal) in the structure of such recording thin film. More specifically, the reading of information is conducted by detecting the change in the reflectivity.

The aforementioned phase change is performed with the irradiation of a laser beam narrowed down to a diameter of approximately 1 to several µm. Here, for example, when a 1 µm laser beam passes through at a linear velocity of 10m/s, light is irradiated to a certain point on the optical disc for 100ns, and it is necessary to perform the aforementioned phase change and detect the reflectivity within such time frame.

Moreover, in order to realize the foregoing crystallographic phase change; that is, the phase change of the amorphous and crystal, not only will the phase change recording layer be exposed to fusion and quenching more than once, the peripheral dielectric protective layer and aluminum alloy will also be repeatedly exposed thereto.

In light of the above, a phase change optical disc has a four-layer structure wherein, for instance, both sides of a Ge-Sb-Te recording thin film layer or the like are sandwiched with a zinc sulfide silicon oxide (ZnS-SiO₂) high-melting point dielectric or the like, and an aluminum alloy reflective layer is additionally provided thereto.

Among the above, in addition to being demanded of an optical function capable of increasing the absorption of the amorphous portion and crystal portion and which has a large reflectivity difference, the reflective layer and protective layer are also demanded of a function for preventing the deformation caused by the moisture resistance or heat of the recording thin film as well as a function for controlling the thermal conditions upon recording (c.f. "Kogaku" magazine, volume 26, no. 1, pages 9 to 15).

As described above, the protective layer of a high-melting point dielectric must be durable against repeated thermal stress caused by the heating and cooling, must not allow such thermal effect to influence the reflective film or other areas, and it is also required to be thin, of low reflectivity, and possess strength to prevent deterioration. From this perspective, the dielectric protective layer plays an important role.

The dielectric protective layer described above is usually formed with the sputtering method. This sputtering method makes a positive electrode target and a negative electrode target face each other, and generates an electric field by applying a high voltage between the substrates thereof and the targets under an inert gas atmosphere. The sputtering method employs a fundamental principle where plasma is formed pursuant to the collision of electrons, which are ionized at such time, and the inert gas, the positive ion in this plasma extrudes the atoms structuring the target by colliding with the target (negative electrode) surface, and the extruded atoms adhere to the opposing substrate surface, wherein the film is formed thereby.

Conventionally, since the aforementioned protective layer is demanded of permeability, heat resistance, and so on in a visible optical band, sputtering is conducted with a ceramic target formed from ZnS-SiO₂ or the like in order to form a thin film of approximately 500 to 2000A.

These materials are deposited with a Radio-frequency sputtering (RF) machine, a magnetron-sputtering machine, or with a DC (direct current) sputtering machine upon conducting special processing to the target material.

The sputtering face of the target can be made even and smooth by miniaturizing and highly densifying the crystal grain of the target formed from zinc sulfide-silicon oxide (ZnS-SiO₂), whereby yielding a characteristic of reducing particles and nodules as well as prolonging the target life. It is well known that the productivity of optical discs can be improved as a result thereof.

Nevertheless, conventionally, the SiO₂ used in a ZnS-SiO₂ target had a high purity of 4N or more and an average grain diameter of 0.1 to 20 µm, and was usually manufactured by being sintered between 800 and 1200°C. Within this kind of temperature range, however, the SiO₂ itself would not deform and would not react with ZnS.

Thus, the ZnS-SiO₂ target manufactured as above easily creates a space between ZnS and SiO₂, which becomes more noticeable when SiO₂ is minute, and, since the precision of ZnS is also hindered thereby, there is a problem in that the target density will deteriorate.

Therefore, conventionally, it was necessary to make the manufacturing conditions of a higher temperature and higher pressing for hot pressing in order to realize high densification. Nevertheless, for instance, when employing the hot pressing method for manufacture, the time required for a single process would increase in proportion to the increase in temperature, and, in order to maintain the strength of the graphite mold in proportion to the increase in pressing, the outer peripheral thickness must be increased and the loading area must be reduced. As a result, there is a problem in that the production volume per batch of hot pressing would decrease significantly.

Contrarily, when enlarging the hot press machine and enlarging the graphite mold itself in order to avoid reducing the production volume, costs for the hot press machine and graphite mold would increase.

Due to the foregoing reasons, conventionally, it was not possible to obtain, at a low cost, a high-density sputtering target for a ZnS-SiO₂ phase change optical disc protective film.

JP 2000-219962 discloses a method for production of sputtering targets for forming an optical recording protective film. Zinc chalcogenide powder having particle size between 4-6 µm and specific area ≤ 5 m²/g is mixed with 10-20 mol. % of SiO₂ having particle size of 1 -12 μm and specific area 5 - 10 m²/g.

Accordingly, in general, there was no choice but to use a low-density target, and, as a result, particles (dust emission) and nodules would arise upon forming a film with sputtering. This led to a problem of deterioration in evenness and quality of the film, and inferior productivity.

### Disclosure of the Invention

An object of the present invention is to obtain a sputtering target comprising a high density of 98%, being higher with minute crystal grains and having zinc sulfide-silicon oxide as its principal components, which is capable of reducing particles (dust emission) and nodules produced during sputtering upon forming a film with sputtering, which is of high density and having minimal variation in quality, and capable of improving mass productiveness, as well as to an optical recording medium having formed thereon the phase change optical disc protective film having zinc sulfide-silicon oxide as its principal component through the use of the foregoing target, and the manufacturing method of such a target.

In order to achieve the foregoing object, as a result of intense study, the present inventors discovered that by adjusting the amount of sulfate radical (SO₄) contained in the zinc sulfide and the specific surface area shape, pores can be reduced, high densification can be easily realized even when it is minute, generation of particles and nodules produced at the time of sputtering can be reduced without detriment to the characteristics as a protective film, and evenness of the film thickness can also be improved.

Based on the foregoing discovery, the present invention provides:
1. A manufacturing method of sputtering target characterized in forming the target through hot pressing or hot isostatic pressing using powder in which zinc sulfide powder and silicon oxide powder are evenly mixed and dispersed, wherein, when the medium grain diameters of zinc sulfide and silicon oxide in which the sulfate radical is 0.05 to 0.35wt% are respectively given as A µm and B µm, and the mixture ratio of silicon oxide is given as Mmol%, 1.4 ≦B/A is satisfied within the range of 0.1µm <A<10 µm, 0.5 µm <B<15 µm and 15mol%≦M; when the specific surface areas are respectively given as Cm²/g and Dm²/g, and the mixture ratio of silicon oxide is given as Mmol%, 3.5 ≦ C/D is satisfied within the range of 5m²/g≦C≦40m²/g, 0.5m²/g≦D≦15m²/g and 15mol%≦M; when the grain diameter A converted specific surface area is given as Em²/g, 15 ≦ C/E; and when the grain diameter B converted specific surface area is given as Fm²/g, D/F ≦ 5;
2. A manufacturing method of a sputtering target according to paragraph 4 above, characterized in that the average grain diameter of the silicon oxide existing in the bulk phase of the target is 10 µm or less;
3. A manufacturing method of a sputtering target according to paragraph 4 or paragraph 5 above, characterized in that the relative density is 98% or higher; and
4. A manufacturing method of a sputtering target according to each of paragraphs 4 to 6 above, characterized in that hot pressing is performed by vacuumizing the atmosphere at least during the rise in temperature or retention of maximum temperature.

Moreover, in the foregoing description, it is given that 0.1 µm <A<10 µm because, if A were 0.1 µm or less, productivity will deteriorate due to the generation of aggregation and deterioration in density, and because, if A were 10 µm or more, it would be difficult to achieve the targeted high densification.

It is given that 5 µm <B<15 µm because, if B were 0.5 µm or less, it would be difficult to achieve the targeted high densification, and because, if B were 15 µm or more, the generation of particles and nodules will increase. If C were less than 5m²/g, it would be difficult to achieve the targeted high densification, and, if C were greater than 40m²/g, productivity will deteriorate due to the generation of aggregation and deterioration in density. Thus, it is given that 5m²/g ≦ C ≦ 40m²/g.

If D were less than 0.5m²/g, the generation of particles and nodules will increase, and, if D were greater than 15m²/g, it would be difficult to achieve the targeted high densification. Thus, it is given that the range is 0.5m²/g ≦ D ≦ 15m²/g.

### Best Mode for Carrying Out the Invention

The sputtering target of the present invention having zinc sulfide- silicon oxide as its principal components is prepared by mixing zinc sulfide powder and silicon oxide powder such that they are dispersed evenly and thereafter sintering the same, wherein, when the medium grain diameters of zinc sulfide in which the sulfate radical is 0.05 to 0.35wt% and silicon oxide are respectively given as A µm and B µm, and the mixture ratio of silicon oxide is given as Mmol%, 1.4 ≦ B/A is satisfied within the range of 0.1 µm <A<10 µm, 0.5 µm <B<15 µm and 15mol% ≦ M; when the specific surface areas are respectively given as Cm²/g and Dm²/g, and the mixture ratio of silicon oxide is given as Mmol%, 3.5 ≦ C/D is satisfied within the range of 5m²/g ≦ C ≦ 40m²/g, 0.5m²/g ≦ D ≦ 15m²/g and 15mol%≦ M; when the grain diameter A converted specific surface area is given as Em²/g, 15 ≦ C/E; and when the grain diameter B converted specific surface area is given as Fm²/g, D/F ≦ 5. Thereby obtained is a sputtering target having a relative density of 98% or higher.

The improvement in density of this type of sputtering target having zinc sulfide-silicon oxide as its principal components will miniaturize crystal grains by decreasing holes and make the sputtering face of the target even and smooth. Thus, significant effects are yielded in that particles and nodules during sputtering can be reduced and the target life can be prolonged.

As a result of the above, productivity of the optical recording medium having formed thereon the phase change optical disc protective film through the use of the sputtering target of the present invention having zinc sulfide- silicon oxide as its principal components is improved, and material superior in quality can thereby be obtained.

Moreover, the foregoing characteristics can be further improved by making the average grain diameter of the silicon oxide existing in the bulk phase of the target 10 µm or less.

As for the manufacturing method of a sputtering target having zinc sulfide- silicon oxide as its principal components, the foregoing zinc sulfide powder and silicon oxide power can be prepared with hot pressing or hot isostatic pressing.

As for hot pressing, a high-density target can easily be prepared by performing hot pressing by way of vacuumizing the atmosphere at least during the rise in temperature or retention of maximum temperature.

Here, with respect to the zinc sulfide raw material, heat treatment of 300°C or higher for the purpose of degassing is no longer required for preparing a high-density target with few holes.

As described above, with a relatively simple method of prescribing the specific surface area of zinc sulfide and sulfate radical (SO₄) contained in the raw material, a significant effect is yielded in that a high-density target with few holes can be manufactured under the ordinary mass production conditions (temperature, pressure, atmosphere) of hot pressing or HIP without altering the quality (crystal grain or crystal phase) of the target.

### Examples and Comparative Examples

The present invention is now described with reference to the Examples and Comparative Examples. These Examples are merely illustrative, and the present invention shall in no way be limited thereby. In other words, the present invention shall only be limited by the scope of claim for a patent, and shall include the various modifications other than the Examples of this invention.

### (Example 1)

Zinc sulfide (ZnS) powder having a purity of 4N (99.99%), specific surface area of 20m²/g (grain diameter converted specific surface area of 0.5m²/g) by the BET method, 0.2wt% of sulfate radical (SO₄), and a grain diameter (median) of 3 µm, and silicon oxide (SiO₂) powder having a purity of 4N (99.99%), specific surface area of 0.8m²/g (grain diameter converted specific surface area of 0.3m²/g) by the BET method, and a grain diameter (median) of 10 µm were evenly mixed at a ratio of 20mol% to ZnS.

This mixed powder was filled in a graphite die, and hot pressed under the conditions of a vacuum atmosphere, a pressure of 150kgf/cm², and a temperature of 1000°C. The target obtained thereby had a relative density of 98.0%.

The average grain diameter of the crystal grain of SiO₂ was 10 µm or less. Moreover, pores on the surface between ZnS and SiO₂ could hardly be acknowledged. As a result, obtained was a superior high-density sputtering target for forming a ZnS-SiO₂ phase change optical disc protective film.

### (Example 2)

Zinc sulfide (ZnS) powder having a purity of 4N, specific surface area of 10m²/g (grain diameter converted specific surface area of 0.3m²/g) by the BET method, 0.11 wt% of sulfate radical (SO₄), and a grain diameter (median) of 51m, and SiO₂ powder having a purity of 4N, specific surface area of 0.9m²/g (grain diameter converted specific surface area of 0.3m²/g) by the BET method, and a grain diameter (median) of 10 µm were evenly mixed at a ratio of 20mol% to ZnS.

This mixed powder was filled in a graphite die, and hot pressed under the conditions of a vacuum atmosphere, a pressure of 150kgf/cm², and a temperature of 1000°C. The target obtained thereby had a relative density of 98.5%.

The average grain diameter of the crystal grain of SiO₂ was 10 µm or less. Moreover, pores on the surface between ZnS and SiO₂ could hardly be acknowledged. As a result, obtained was a superior high-density sputtering target for forming a ZnS-SiO₂ phase change optical disc protective film.

### (Example 3)

Zinc sulfide (ZnS) powder having a purity of 4N, specific surface area of 30m²/g (grain diameter converted specific surface area of 1.5m²/g) by the BET method, 0.35wt% of sulfate radical (SO₄), and a grain diameter (median) of 1 µm, and SiO₂ powder having a purity of 4N, specific surface area of 0.9m²/g (grain diameter converted specific surface area of 0.3m²/g) by the BET method, and a grain diameter (median) of 10 µm were evenly mixed at a ratio of 20mol% to ZnS.

This mixed powder was filled in a graphite die, and hot pressed under the conditions of a vacuum atmosphere, a pressure of 150kgf/cm², and a temperature of 1000°C. The target obtained thereby had a relative density of 99.0%.

The average grain diameter of the crystal grain of SiO₂ was 10 µm or less. Moreover, pores on the surface between ZnS and SiO₂ could hardly be acknowledged. As a result, obtained was a superior high-density sputtering target for forming a ZnS-SiO₂ phase change optical disc protective film.

### (Example 4)

ZnS powder having a purity of 4N, specific surface area of 7m²/g (grain diameter converted specific surface area of 0.3m²/g) by the BET method, 0.15wt% of sulfate radical (SO₄), and a grain diameter (median) of 5 µm, and SiO₂ powder having a purity of 4N, specific surface area of 1.3m²/g (grain diameter converted specific surface area of 0.3m²/g) by the BET method, and a grain diameter (median) of 9 µm were evenly mixed at a ratio of 20mol% to ZnS.

This mixed powder was filled in a graphite die, and hot pressed under the conditions of a vacuum atmosphere, a pressure of 150kgf/cm², and a temperature of 1100°C. The target obtained thereby had a relative density of 98.5%.

The average grain diameter of the crystal grain of SiO₂ was 10 µm or less. Moreover, pores on the surface between ZnS and SiO₂ could hardly be acknowledged. As a result, obtained was a superior high-density sputtering target for forming a ZnS-SiO₂ phase change optical disc protective film.

### (Example 5)

ZnS powder having a purity of 4N, specific surface area of 10m²/g (grain diameter converted specific surface area of 0.5m²/g) by the BET method, 0.12wt% of sulfate radical (SO₄), and a grain diameter (median) of 3 µm, and SiO₂ powder having a purity of 4N, specific surface area of 2.5m²/g (grain diameter converted specific surface area of 0.5m²/g) by the BET method, and a grain diameter (median) of 5 µm were evenly mixed at a ratio of 20mol% to ZnS.

This mixed powder was filled in a graphite die, and hot pressed under the conditions of a vacuum atmosphere, a pressure of 150kgf/cm², and a temperature of 1100°C. The target obtained thereby had a relative density of 99.5%.

The average grain diameter of the crystal grain of SiO₂ was 10 µm or less. Moreover, pores on the surface between ZnS and SiO₂ could hardly be acknowledged. As a result, obtained was a superior high-density sputtering target for forming a ZnS-SiO₂ phase change optical disc protective film.

### (Example 6)

ZnS powder having a purity of 4N, specific surface area of 20m²/g (grain diameter converted specific surface area of 0.5m²/g) by the BET method, 0.22wt% of sulfate radical (SO₄), and a grain diameter (median) of 3 µm, and SiO₂ powder having a purity of 4N, specific surface area of 1.8m²/g (grain diameter converted specific surface area of 0.5m²/g) by the BET method, and a grain diameter (median) of 6 µm were evenly mixed at a ratio of 20mol% to ZnS.

This mixed powder was filled in a graphite die, and hot pressed under the conditions of a vacuum atmosphere, a pressure of 150kgf/cm², and a temperature of 1100°C. The target obtained thereby had a relative density of 98.5%.

The average grain diameter of the crystal grain of SiO₂ was 10 µm or less. Moreover, pores on the surface between ZnS and SiO₂ could hardly be acknowledged. As a result, obtained was a superior high-density sputtering target for forming a ZnS-SiO₂ phase change optical disc protective film.

### (Example 7)

ZnS powder having a purity of 4N, specific surface area of 30m²/g (grain diameter converted specific surface area of 1.5m²/g) by the BET method, 0.25wt% of sulfate radical (SO₄), and a grain diameter (median) of 1 µm, and SiO₂ powder having a purity of 4N, specific surface area of 0.7m²/g (grain diameter converted specific surface area of 0.2m²/g) by the BET method, and a grain diameter (median) of 11 µm were evenly mixed at a ratio of 20mol% to ZnS.

This mixed powder was filled in a graphite die, and hot pressed under the conditions of a vacuum atmosphere, a pressure of 150kgf/cm², and a temperature of 1100°C. The target obtained thereby had a relative density of 99.4%.

The average grain diameter of the crystal grain of SiO₂ was 10 µm or less. Moreover, pores on the surface between ZnS and SiO₂ could hardly be acknowledged. As a result, obtained was a superior high-density sputtering target for forming a ZnS-SiO₂ phase change optical disc protective film.

### (Summary of Examples 1 to 7)

As illustrated in foregoing Examples 1 to 7, by adjusting the amount of sulfate radical (SO₄) and prescribing both the median grain diameter and specific surface area of the zinc sulfide powder and silicon oxide powder within the scope of the present invention, a sputtering target comprising a high-density of a relative density of 98% or higher and having zinc sulfide and silicon oxide as its principal components can be manufactured in a stable manner. These conditions are particularly important. The results are shown in Table 1.

### Table 1. Examples and Comparative Examples of Present Invention

### (Comparative Example 1)

ZnS powder having a purity of 4N, specific surface area of 10m²/g (grain diameter converted specific surface area of 0.3m²/g) by the BET method, 0.7wt% (outside the scope of present invention) of sulfate radical (SO₄), and a grain diameter (median) of 5 µm, and SiO₂ powder having a purity of 4N, specific surface area of 0.5m²/g (grain diameter converted specific surface area of 0.1m²/g) by the BET method, and a grain diameter (median) of 20 µm (outside the scope of present invention) were evenly mixed at a ratio of 20mol% to ZnS.

This mixed powder was filled in a graphite die, and hot pressed under the conditions of a vacuum atmosphere, a pressure of 150kgf/cm², and a temperature of 1000°C. The target obtained thereby had a relative density of 85.0%.

The average grain diameter of the crystal grain of SiO₂ was 20 µm. Moreover, numerous pores on the surface between ZnS and SiO₂ were acknowledged. As a result, obtained was a sputtering target inferior in density. The conditions and results are shown in Table 1.

### (Comparative Example 2)

ZnS powder having a purity of 4N, specific surface area of 8m²/g (grain diameter converted specific surface area of 0.3m²/g) by the BET method, 0.45wt% (outside the scope of present invention) of sulfate radical (SO₄), and a grain diameter (median) of 5 µm, and SiO₂ powder having a purity of 4N, specific surface area of 0.7m²/g (grain diameter converted specific surface area of 0.2m²/g) by the BET method, and a grain diameter (median) of 12 µm (outside the scope of present invention) were evenly mixed at a ratio of 20mol% to ZnS.

This mixed powder was filled in a graphite die, and hot pressed under the conditions of a vacuum atmosphere, a pressure of 150kgf/cm², and a temperature of 1100°C. The target obtained thereby had a relative density of 96.0%. The amount of sulfate radical (SO₄) to be added considerably affects the deterioration in density. The conditions and results are shown in Table 1.

### (Comparative Example 3)

ZnS powder having a purity of 4N, specific surface area of 9m²/g (grain diameter converted specific surface area of 0.3m²/g) by the BET method, 0.21 wt% of sulfate radical (SO₄), and a grain diameter (median) of 5 µm, and SiO₂ powder having a purity of 4N, specific surface area of 2.5m²/g (grain diameter converted specific surface area of 0.5m²/g) by the BET method, and a grain diameter (median) of 5 µm were evenly mixed at a ratio of 20mol% to ZnS.

This mixed powder was filled in a graphite die, and hot pressed under the conditions of a vacuum atmosphere, a pressure of 150kgf/cm², and a temperature of 1100°C. The target obtained thereby had a relative density of 94.0%. The conditions and results are shown in Table 1.

### (Comparative Example 4)

ZnS powder having a purity of 4N, specific surface area of 4m²/g (grain diameter converted specific surface area of 0.3m²/g) by the BET method, 0.18wt% of sulfate radical (SO₄), and a grain diameter (median) of 5 µm, and SiO₂ powder having a purity of 4N, specific surface area of 1.6m²/g (grain diameter converted specific surface area of 0.3m²/g) by the BET method, and a grain diameter (median) of 8 µm were evenly mixed at a ratio of 20mol% to ZnS.

This mixed powder was filled in a graphite die, and hot pressed under the conditions of a vacuum atmosphere, a pressure of 150kgf/cm², and a temperature of 1100°C. The target obtained thereby had a relative density of 92.0%, and showed a significant decrease. The conditions and results are shown in Table 1. (Comparative Example 5)

ZnS powder having a purity of 4N, specific surface area of 2.5m²/g (grain diameter converted specific surface area of 0.2m²/g) by the BET method, 0.2wt% of sulfate radical (SO₄), and a grain diameter (median) of 8 µm, and SiO₂ powder having a purity of 4N, specific surface area of 2.3m²/g (grain diameter converted specific surface area of 0.5m²/g) by the BET method, and a grain diameter (median) of 5 µm were evenly mixed at a ratio of 20mol% to ZnS.

This mixed powder was filled in a graphite die, and hot pressed under the conditions of a vacuum atmosphere, a pressure of 150kgf/cm², and a temperature of 1100°C. The target obtained thereby had a relative density of 88.0%, and showed a significant decrease. The conditions and results are shown in Table 1. (Comparative Example 6)

ZnS powder having a purity of 4N, specific surface area of 20m²/g (grain diameter converted specific surface area of 0.3m²/g) by the BET method, 0.18wt% of sulfate radical (SO₄), and a grain diameter (median) of 5 µm, and SiO₂ powder having a purity of 4N, specific surface area of 5.0m²/g (grain diameter converted specific surface area of 0.4m²/g) by the BET method, and a grain diameter (median) of 7 µm were evenly mixed at a ratio of 20mol% to ZnS.

This mixed powder was filled in a graphite die, and hot pressed under the conditions of a vacuum atmosphere, a pressure of 150kgf/cm², and a temperature of 1100°C. The target obtained thereby had a relative density of 93.5%, and was of low density. The conditions and results are shown in Table 1. (Comparative Example 7)

ZnS powder having a purity of 4N, specific surface area of 2.5m²/g (grain diameter converted specific surface area of 0.2m²/g) by the BET method, 0.17wt% of sulfate radical (SO₄), and a grain diameter (median) of 8 µm, and SiO₂ powder having a purity of 4N, specific surface area of 0.7m²/g (grain diameter converted specific surface area of 0.2m²/g) by the BET method, and a grain diameter (median) of 12 µm were evenly mixed at a ratio of 20mol% to ZnS.

This mixed powder was filled in a graphite die, and hot pressed under the conditions of a vacuum atmosphere, a pressure of 150kgf/cm², and a temperature of 1100°C. The target obtained thereby had a relative density of 93.1%, and was of low density. The conditions and results are shown in Table 1. (Comparative Example 8)

ZnS powder having a purity of 4N, specific surface area of 30m²/g (grain diameter converted specific surface area of 1.5m²/g) by the BET method, 0.25wt% of sulfate radical (SO₄), and a grain diameter (median) of 1 µm, and SiO₂ powder having a purity of 4N, specific surface area of 8.8m²/g (grain diameter converted specific surface area of 1.8m²/g) by the BET method, and a grain diameter (median) of 1.5 µm were evenly mixed at a ratio of 20mol% to ZnS.

This mixed powder was filled in a graphite die, and hot pressed under the conditions of a vacuum atmosphere, a pressure of 150kgf/cm², and a temperature of 1100°C. The target obtained thereby had a relative density of 90.3%, and was of low density. The conditions and results are shown in Table 1.

### (Comparative Example 9)

ZnS powder having a purity of 4N, specific surface area of 2.4m²/g (grain diameter converted specific surface area of 0.1m²/g) by the BET method, 0.11 wt% of sulfate radical (SO₄), and a grain diameter (median) of 10 µm, and SiO₂ powder having a purity of 4N, specific surface area of 0.2m²/g (grain diameter converted specific surface area of 0.2m²/g) by the BET method, and a grain diameter (median) of 14 µm were evenly mixed at a ratio of 20mol% to ZnS.

This mixed powder was filled in a graphite die, and hot pressed under the conditions of a vacuum atmosphere, a pressure of 150kgf/cm², and a temperature of 1100°C. The target obtained thereby had a relative density of 95.5%, and was of low density. The conditions and results are shown in Table 1.

### (Comparative Example 10)

ZnS powder having a purity of 4N, specific surface area of 45m²/g (grain diameter converted specific surface area of 0.2m²/g) by the BET method, 0.3wt% of sulfate radical (SO₄), and a grain diameter (median) of 6 µm, and SiO₂ powder having a purity of 4N, specific surface area of 12m²/g (grain diameter converted specific surface area of 6.8m²/g) by the BET method, and a grain diameter (median) of 0.4 µm were evenly mixed at a ratio of 20mol% to ZnS.

This mixed powder was filled in a graphite die, and hot pressed under the conditions of a vacuum atmosphere, a pressure of 150kgf/cm², and a temperature of 1100°C. The target obtained thereby had a relative density of 84.0%, and showed a significant decrease in density. The conditions and results are shown in Table 1.

### (Summary of Examples and Comparative Examples)

As illustrated in the foregoing Examples and Comparative Examples, by prescribing the amount of sulfate radical (SO₄) contained in the zinc sulfide and both the median grain diameter and specific surface area of zinc sulfide and silicon oxide to be within the scope of the present invention, effects are yielded in that pores can be reduced, high densification; that is, a relative density of 98% or higher can be achieved easily even upon miniaturization thereof, characteristics as a protective film will not be lost, particles and nodules produced during sputtering can be reduced, and the evenness of the film thickness can also be improved.

With Comparative Examples 1 to 10 that are outside the scope of the present invention, there are problems in that the density decreased radically, particles (dust emission) and nodules produced during sputtering increased, and characteristics as a phase change optical disc protective film were impaired.

### Effect of the Invention

The present invention yields a significant effect in that it provides a sputtering target having zinc sulfide- silicon oxide as its principal components, which is capable of reducing particles (dust emission) and nodules produced during sputtering upon forming a film with sputtering, has minimal variation in quality and capable of improving mass productiveness, and which has a high density of a relative density of 98% or higher. Moreover, without impairing the characteristics as a protective film, obtained is an optical recording medium having formed thereon the phase change optical disc protective film having zinc sulfide-silicon oxide as its principal component through the use of such target.

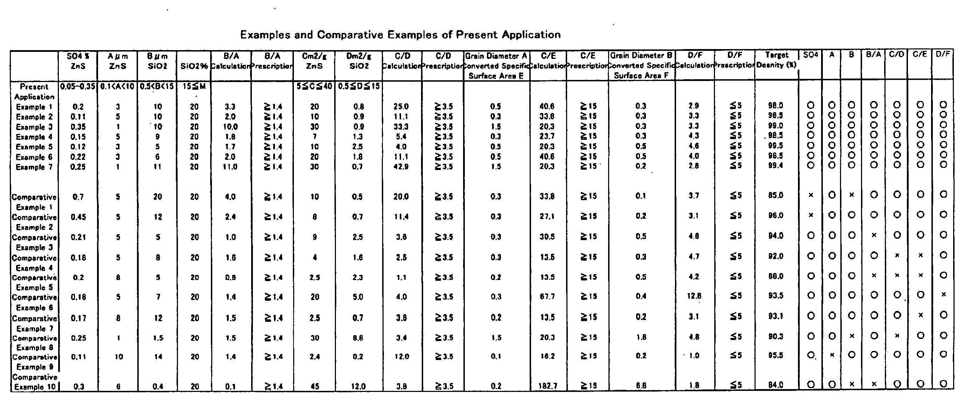

## Claims

1. A manufacturing method of sputtering target **characterized in** forming said target through hot pressing or hot isostatic pressing using powder in which zinc sulfide powder and silicon oxide powder are evenly mixed and dispersed, wherein, when the medium grain diameters of zinc sulfide in which the sulfate radical is 0.05 to 0.35wt% and silicon oxide are respectively given as A µm and B µm, and the mixture ratio of silicon oxide is given as Mmol%, 1.4 ≦ B/A is satisfied within the range of 0.1 µm <A<10 µm, 0.5 µm <B<15 µm and 15mo1% ≦M; when the specific surface areas are respectively given as Cm²/g and Dm²/g, and the mixture ratio of silicon oxide is given as Mmol%, 3.5 ≦ C/D is satisfied within the range of 5m²/g ≦ C ≦ 40m²/g, 0.5m²/g ≦D ≦ 15m²/g and 15mol% ≦ M; when the grain diameter A converted specific surface area is given as Em²/g, 15 ≦ C/E; and when the grain diameter B converted specific surface area is given as Fm²/g, D/F ≦ 5.

2. A manufacturing method of a sputtering target according to claim 1, **characterized in that** the average grain diameter of the silicon oxide existing in the bulk phase of the target is 10 µm or less.

3. A manufacturing method of a sputtering target according to claim 1 or claim 2. **characterized in that** the relative density is 98% or higher

4. A manufacturing method of a sputtering target according to each of claims 1 to 3, **characterized in that** hot pressing is performed by vacuumizing the atmosphere at least during the rise in temperature or retention of maximum temperature.

## Patentansprüche

1. Verfahren zur Herstellung eines Sputtertargets, **gekennzeichnet durch** das Formen dieses Targets **durch** Heißpressen oder heißisostatisches Pressen mit einem Pulver, in dem Zinksulfidpulver und Siliziumoxidpulver gleichmäßig gemischt und verteilt sind, wobei, wenn die mittlere Körnung des Zinksulfids, in dem das Sulfat-Radikal 0,05 bis 0,35 Gewichtprozent ausmacht, und die des Siliziumoxids mit A µm bzw. B µm bezeichnet werden und das Mischungsverhältnis des Siliziumoxids als Mmol% angegeben ist, 1,4 ≤ B/A erfüllt ist im Bereich von 0,1 µm <A< 10 µm, 0,5 µm <B<15 µm und 15 mol% ≤ M; wenn die spezifischen Oberflächen jeweils als Cm²/g und Dm³/g angegeben werden und das Mischungsverhältnis von Siliziumoxid in Mmol% angegeben wird, 3,5 ≤ C/D erfüllt ist im Bereich 5m²/g ≤ C ≤ 40m²/g, 0,5m²/g ≤ D ≤ 15m²/g und 15mol% ≤ M; wenn die für Körnung A berechnete spezifische Oberfläche als Em²/g angegeben ist, 15≤C/E; und wenn die für Körnung B berechnete spezifische Oberfläche als Fm²/g angegeben wird, D/F≤5.

2. Verfahren zur Herstellung eines Sputtertargets nach Anspruch 1, **dadurch gekennzeichnet, dass** die durchschnittliche Körnung des Siliziumoxids in der Bulk Phase des Targets 10 µm oder weniger beträgt.

3. Verfahren zur Herstellung eines Sputtertargets nach Anspruch 1 oder 2, **dadurch gekennzeichnet, dass** die relative Dichte 98 % oder mehr beträgt.

4. Verfahren zur Herstellung eines Sputtertargets nach jedem der Ansprüche 1 bis 3, **dadurch gekennzeichnet, dass** das Heißpressen erfolgt, indem die Atmosphäre mindestens während des Temperaturanstiegs oder während der Dauer der maximalen Temperatur vakuumisiert wird.

## Revendications

1. Un procédé de fabrication d'une cible de pulvérisation **caractérisé par** la formation de ladite cible par compression à chaud ou compression isostatique à chaud au moyen d'une poudre dans laquelle une poudre de sulfure de zinc et une poudre d'oxyde de silicium sont mélangées et dispersées de manière homogène, où, lorsque les diamètres de grain moyens de sulfure de zinc dont le radical sulfate est de 0,05 à 0,35 % en poids et l'oxyde de silicium sont donnés respectivement sous la forme A µm et B µm, et le rapport de mélange d'oxyde de silicium est donné sous la forme Mmol%, 1,4 ≤ B/A est satisfait dans la plage de 0,1 µm < A < 10 µm, 0,5 µm < B < 15 µm et 15 mol% ≤ M, lorsque les surfaces spécifiques sont données respectivement sous la forme Cm²/g et Dm²/g, et le rapport de mélange d'oxyde de silicium est donné sous la forme Mmol%, 3,5 ≤ C/D est satisfait dans la plage de 5m²/g ≤ C ≤ 40m²/g, 0,5m²/g ≤ D ≤ 15m²/g et 15mol% ≤ M, lorsque la surface spécifique convertie du diamètre de grain A est donnée sous la forme Em²/g, 15 ≤ C/E et lorsque la surface spécifique convertie du diamètre de grain B est donnée sous la forme Fm²/g, D/F ≤ 5.

2. Un procédé de fabrication d'une cible de pulvérisation selon la revendication 1, **caractérisé en ce que** le diamètre de grain moyen de l'oxyde de silicium existant dans la phase volumique de la cible est de 10 µm ou moins.

3. Un procédé de fabrication d'une cible de pulvérisation selon la revendication 1 ou 2, **caractérisé en ce que** la densité relative est de 98% ou plus.

4. Un procédé de fabrication d'une cible de pulvérisation selon l'une quelconque des revendications 1 à 3, **caractérisé en ce que** la compression à chaud est exécutée en mettant sous vide l'atmosphère au moins pendant la montée en température ou la conservation de la température maximale.
